Europäisches Patentamt

European Patent Office

Office européen des brevets

(11) Veröffentlichungsnummer: **0 095 998**
**A1**

(12) # EUROPÄISCHE PATENTANMELDUNG

(21) Anmeldenummer: 83710029.6

(22) Anmeldetag: 24.05.83

(51) Int. Cl.³: **G 01 R 15/07**, G 02 F 1/015,
H 01 L 31/14

(30) Priorität: 02.06.82 SE 8203391

(71) Anmelder: **ASEA AB, S-721 83 Västeras (SE)**

(72) Erfinder: **Adolfsson, Morgan, Dipl.-Ing., Sigfrid Edströms Gata 86, S-724 66 Västeras (SE)**
Erfinder: **Brogardh, Torgny, Prof., Platverksgatan 140, S-724 74 Västeras (SE)**
Erfinder: **Hök, Bertil, Dr. Phil., Sportfiskargatan 53, S-723 48 Västeras (SE)**
Erfinder: **Ovrén, Christer, Dr. Ing., Vilddjursvägen 9, S-722 43 Västeras (SE)**

(43) Veröffentlichungstag der Anmeldung: 07.12.83
Patentblatt 83/49

(84) Benannte Vertragsstaaten: **CH DE FR GB LI**

(74) Vertreter: **Boecker, Joachim, Dr.-Ing., Rathenauplatz 2-8, D-6000 Frankfurt a.M. 1 (DE)**

(54) **Faseroptische Messanordnung.**

(57) Faseroptische Messanordnung zum Messen von physikalischen Grössen, insbesondere einer elektrischen Spannung oder eines Magnetfeldes, mit einem Geber, der über mindestens eine optische Faser (8) mit einer Messelektronikeinheit verbunden ist, wobei die Messelektronik mindestens zwei Lichtquellen mit getrennten Emissionsspektren zur Erzeugung einer Fotoluminiszenz in einem im Geber vorhandenen Sensorelement enthält und mindestens einen Fotodetektor zur Erfassung des von dem Sensorelement ausgehenden Luminiszenzlichtes enthält. Gemäss der Erfindung enthält das Sensorelement mindestens eine luminiszierende Schicht (28), wobei zwischen dieser Schicht (28) und der optischen Faser (8) nebeneinander Filter (31, 32) mit unterschiedlicher Transparenzcharakteristik angeordnet sind. Das von der Elektronikeinheit kommende Anregungslicht kann durch mindestens einen dieser Filter (32) zu der Schicht (28) gelangen, in der es Ladungsträger erzeugt. Diese Ladungsträger werden durch ein laterales elektrisches Feld (29a. 29b), welches von der zu messenden Spannung (U) erzeugt wird, in andere Bereiche der Schicht (28) gezogen, in der sie rekombinieren. Das dabei entstehende Lumineszenzlicht gelangt durch den vorgeschalteten Filter (31) und die Faser (8) zurück zur Messelektronik.

ACTORUM AG

Patentanwalt und Rechtsanwalt
r.-Ing. Dipl.-Ing. Joachim B o e c k e r

6 Frankfurt/Main 1
Rathenauplatz 2-8
Telefon: (0611) *282355
Telex: 4189066 itax d

0095998

, 5.5.1983
B/d 21 280 PE

— 1 —

<u>A S E A</u>   <u>Aktiebolag</u>

<u>Västeras/Schweden</u>

Faseroptische Meßanordnung

Die Erfindung betrifft eine faseroptische Meßanordnung gemäß dem Oberbegriff des Anspruches 1.

Bei einer elektrischen Starkstromanlage besteht ein großes Bedürfnis, elektrische Ströme und Spannungen mit Hilfe von Lichtleitern (optischen Fasern) auf einfache, billige und zuverlässige Weise messen zu können. Solche Meßanordnungen sind beispielsweise bekannt aus den EP-PSen 79 10 3445.7 und 79 10 3755.9. Bei diesen Anordnungen ist jedoch die Sensorelektronik oder Sensormechanik zu kompliziert, um für billige und zuverlässige Meßsysteme verwendet werden zu können. In diesem Zusammenhang besteht der Wunsch, einen einfachen und zuverlässigen Sensor zu entwickeln, der am Ende einer optischen Faser angeordnet ist und der eine elektrische Spannung, einen elektrischen Strom oder ein Magnetfeld erfassen und die Meßgröße schnell und mit großer Genauigkeit in ein optisches Signal umwandeln kann.

Eine Möglichkeit in diesem Zusammenhang besteht darin, einen Strom mit Hilfe einer Leuchtdiode zu messen, wobei die Temperaturabhängigkeit der Leuchtdiode durch eine gleichzeitige Messung der Spektralverteilung des Emissionsspektrums kompensiert wird (DE-OS 30 39 471). Bei einer solchen Meßanordnung muß man jedoch eine Kontrolle über die Alterungserscheinungen in der Leuchtdiode haben, da sie das Meßergebnis beeinflussen. Eine solche Kontrolle ist schwierig herzustellen, wenn man gleichzeitig verlangt, daß die Meß-

/2

anordnung billig sein soll. Das Hauptproblem bei der Alterung von Leuchtdioden besteht in den durch den Injektionsstrom verursachten Kristallfehlern in dem lichtemittierenden Bereich sowie in einer steigenden Anzahl von nichtstrahlenden Rekombinationen im pn-Übergang durch Eindiffundieren von tiefen Rekombinationszentren, wie z.B. $Cu^+$.

Der Erfindung liegt die Aufgabe zugrunde, eine Meßanordnung der eingangs genannten Art zu entwickeln, bei der die Meßgröße auf einfache und zuverlässige Weise von Alterungseinflüssen und anderen störenden Einflüssen freigehalten werden kann.

Zur Lösung dieser Aufgabe wird eine faseroptische Meßanordnung nach dem Oberbegriff des Anspruches 1 vorgeschlagen, die erfindungsgemäß die im kennzeichnenden Teil des Anspruches 1 genannten Merkmale aufweist.

Ausgestaltungen der Erfindung sind in den weiteren Ansprüchen genannt.

Bei der Erfindung wird der Injektionsprozeß in einem pn-Übergang durch optische Erzeugung von Ladungsträgern in einer lateralen Lumineszenzschicht ersetzt, die erzeugten Ladungsträger werden mit Hilfe eines elektrischen und eventuell eines magnetischen Feldes verschoben und diese Verschiebung wird in bestimmter Weise optisch abgetastet. Die Aufgabe des in der lumineszierenden Schicht erzeugten elektrischen Feldes besteht darin, die durch das von der Meßelektronik kommende Anregungslicht erzeugten Ladungsträger zu beschleunigen, so daß die Rekombination der Ladungsträger und damit die Lumineszenz in einem Bereich der Schicht 28 stattfinden kann, von dem das Lumineszenzlicht über die Faser zurück zur Meßelektronik gelangen kann. Mit dieser völlig neuen Technik zur optischen Abtastung von elektrisch oder magnetisch gesteuerten Ladungsträgern in einer lumineszierenden Schicht erhält man einfache und stabile Geber

- 3 -

für Spannung und Strom, die es zusammen mit einer einfachen faseroptischen Meßanordnung ermöglichen, den Strom und die Spannung unbeeinflußt von Reflexionen und variierenden Dämpfungen im Fasersystem und unbeeinflußt von der Temperatur und der Alterung des Gebers zu messen.

Anhand der Figuren soll die Erfindung näher erläutert werden. Es zeigen:

Fig. 1   ein vollständiges Ausführungsbeispiel einer Meßanordnung gemäß der Erfindung,

Fig. 2   in seitlicher Darstellung ein Sensorelement gemäß der Erfindung zum Messen einer Gleichspannung,

Fig. 3   das Sensorelement gemäß Fig. 2 von vorn gesehen,

Fig. 4   die spektralen Zusammenhänge für die Anordnung nach Fig. 1 bei Verwendung des Sensorelementes nach Fig. 2 und 3,

Fig. 5   in seitlicher Darstellung ein Sensorelement zum Messen einer Wechselspannung,

Fig. 6   die entsprechenden spektralen Zusammenhänge bei Verwendung eines Sensorelementes nach Fig. 5,

Fig. 7   in seitlicher Darstellung ein Sensorelement gemäß der Erfindung zum Messen von kleinen Spannungen,

Fig. 8   das Sensorelement gemäß Fig. 7 von vorn gesehen,

Fig. 9   ein Sensorelement mit Feldeffektelektrode zur hochohmigen Spannungssteuerung,

Fig. 10  ein Sensorelement zur Messung eines Magnetfeldes.

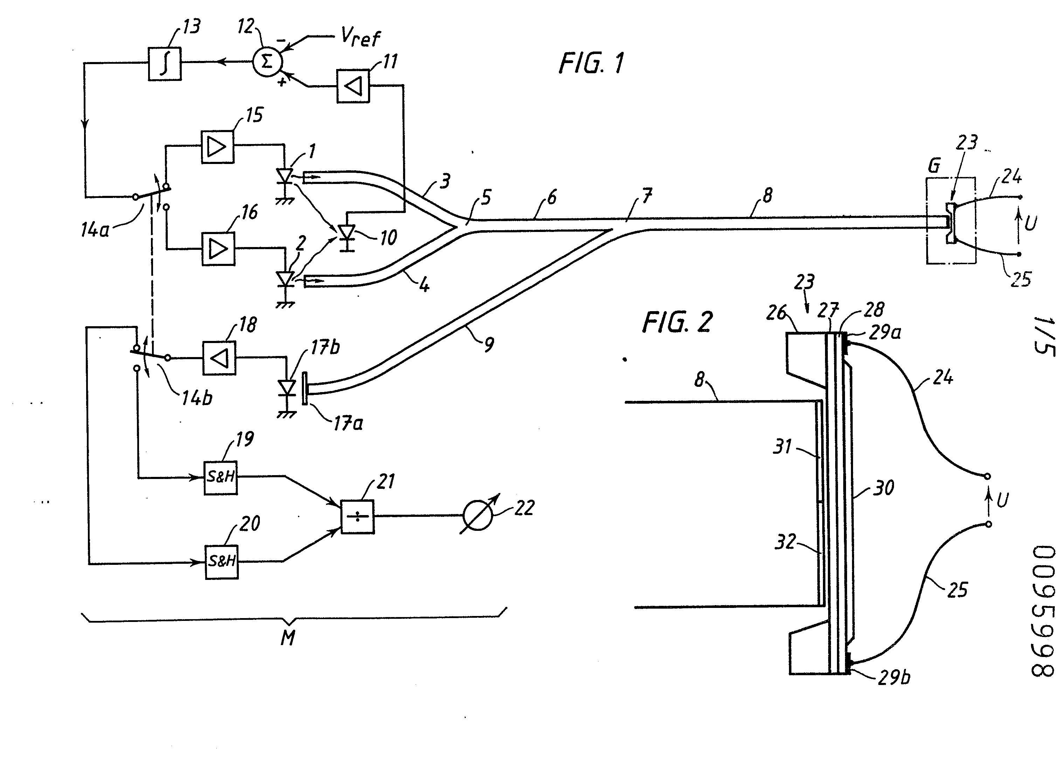

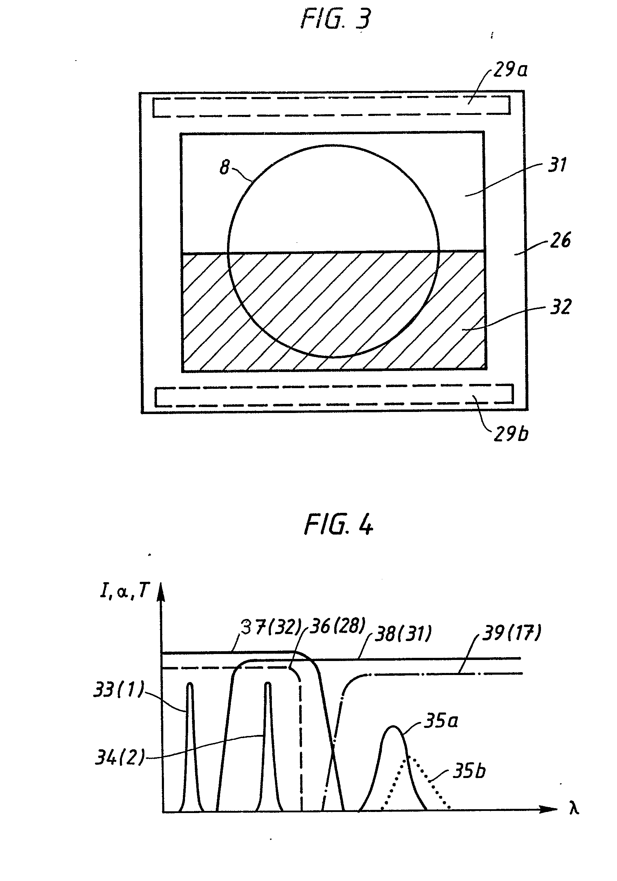

Bei der Meßanordnung nach der Erfindung gemäß Figur 1 wird ein Sensorelement 23 abwechselnd durch zwei Lichtquellen 1 und 2 angeregt, deren Licht getrennte Emissionsspektren 33 und 34 hat (siehe Fig. 4). Das durch Fotolumineszenz erzeugte Licht (35 in Fig. 4) des Sensorelementes wird über die optischen Fasern 8 und 9 über ein Filter 17a auf eine Fotodiode 17b geleitet. Das von der Fotodiode 17b erzeugte

- 4 -

Detektorsignal wird in einem Verstärker 18 verstärkt und über einen Schalter 14b, der synchron mit dem Schalter 14a hin- und hergeschaltet wird, abwechselnd den Folge- und Haltegliedern 19 und 20 zugeführt. Diese Glieder speichern die an ihrem Eingang kurzfristig angelegten Signale und geben sie als Ausgangssignale ab, bis ein neues Signal an ihrem Eingang erscheint. Aus den Ausgangssignalen der beiden Folge- und Halteglieder 19 und 20 wird in einem Quotientenbilder 21 der Quotient gebildet, der auf ein Anzeigeglied 22 gegeben wird. Zur Steuerung der Intensität des Lichtes der Lichtquellen 1 und 2 wird das von diesen emittierte Licht durch einen Fotodetektor (z.B. Fotodiode) 10 gemessen, und der Meßwert wird über einen Verstärker 11 auf ein Summierungsglied 12 gegeben, wo er mit einem Sollwert $V_{ref}$ verglichen wird. Die Regelabweichung steuert einen Regler 13, dessen Ausgangssignal durch den Schalter 14a abwechselnd auf die beiden Speiseglieder 15 und 16 gegeben wird. Zur Übertragung von Licht zwischen den zur Meßanordnung gehörenden optischen Bauteilen werden optische Fasern (3, 4, 6, 8, 9) und optische Verzweigungen (5 und 7) verwendet.

Das Meßprinzip soll anhand der Figuren 1 bis 4 erklärt werden, wobei Figur 2 das Sensorelement von der Seite und Figur 3 das Sensorelement von vorn zeigt. Das in dem Geber G enthaltene Sensorelement besteht aus folgenden Teilen (siehe Fig. 2 und 3):An der Stirnseite der optischen Faser 8, die Licht zu und von dem Sensorelement 23 leitet, befindet sich ein Interferenz- oder Absorptionsfilter 31 mit dem Transmissionsspektrum 38 (gemäß Fig. 4) und ein Interferenz- oder Absorptionsfilter 32 mit dem Transmissionsspektrum 37. Auf einem Substrat 26 aus GaAs ist eine erste epitaxiale Schicht 27 aus $Al_{x1}Ga_{1-x1}As$ vorhanden mit der Aufgabe, optisch angeregte Ladungsträger in der Schicht 28 einzuschließen und Anregungslicht mit den Spektren 33 und 34 hindurchzulassen. Die Schicht 28 ist eine Epitaxial-

/5

- 5 -

schicht aus $Al_{x2}Ga_{1-x_2}As$, wobei $x_2 < x_1$ ist, mit hoher Lumineszenzeffektivität. Sie hat das Absorptionsspektrum 36. Das Lumineszenzspektrum 35a gilt für eine niedrigere Temperatur als das Lumineszenzspektrum 35b. 29a und 29b sind elektrische (am besten ohmsche) Kontakte für die Schicht 28. Die Epitaxialschicht 30 besteht aus $Al_{x3}Ga_{1-x3}As$, wobei $x_3 > x_2$ ist, und hat die Aufgabe, optisch angeregte Ladungsträger in der Schicht 28 einzuschließen. 24 und 25 sind Zuleitungen zum Anschluß der Meßspannung U.

Wenn die Leuchtdiode 1 Licht emittiert (Emissionsspektrum 33), so wird nur der Teil der Schicht 28, der von dem Filter 32 überdeckt ist, (Transmissionsspektrum 37) angeregt, da das Filter 31 (Transmissionsspektrum 38) dieses Licht sperrt. Wenn die Leuchtdiode 2 (Emissionsspektrum 34) Licht emittiert, so erhält die ganze Schicht 28 vor der Endfläche der Faser 8 Licht. Gleichzeitig hat das Filter 32 ein solches Transmissionsspektrum (37), daß es das Lumineszenzlicht 35 von der Schicht 28 sperrt, so daß normalerweise kein Fotolumineszenzsignal zu dem Fotodetektor 17b gelangt, wenn die Leuchtdiode 1 emittiert. Wenn nun eine Spannung U gemäß Figur 2 angelegt wird, und die Schicht 28 p-dotiert (p-leitend) ist, so wird ein Teil der von der Leuchtdiode 1 in der Schicht 28 hinter dem Filter 32 angeregten Elektronen von dem von U erzeugten lateralen elektrischen Feld in der Schicht 28 in denjenigen Teil der Schicht 28 hinübergezogen, der sich unter dem Filter 31 mit dem Transmissionsspektrum 38 befindet, wodurch man ein Lumineszenzsignal im Detektor 17b erhält, das von der Größe von U abhängig ist. Wenn unter denselben Bedingungen die Leuchtdiode 2 eingeschaltet ist, so erhält die gesamte Schicht 28 Licht, und die Lumineszenz von Teilen der Schicht 28, die sich unter dem Filter 31 befinden, sind von U unabhängig. Durch Quotientenbildung im Quotientenbilder 21 aus den von den Leuchtdioden 1 und 2 angeregten Lumineszenzsignalen erhält man auf diese Weise ein Signal, das von der Spannung U abhängig und gegenüber variierender Dämpfung im Fasersystem,

- 6 -

variierender Temperatur des Gebers und Alterung des Sensor-elementes 23 kompensiert ist. Um den Einfluß von Reflexionen des Anregungslichtes im Fasersystem zu vermeiden, wird das Anregungslicht vor dem Detektor 17b durch das optische Filter 17a mit dem Transmissionsspektrum 39 (Fig. 4) gesperrt.

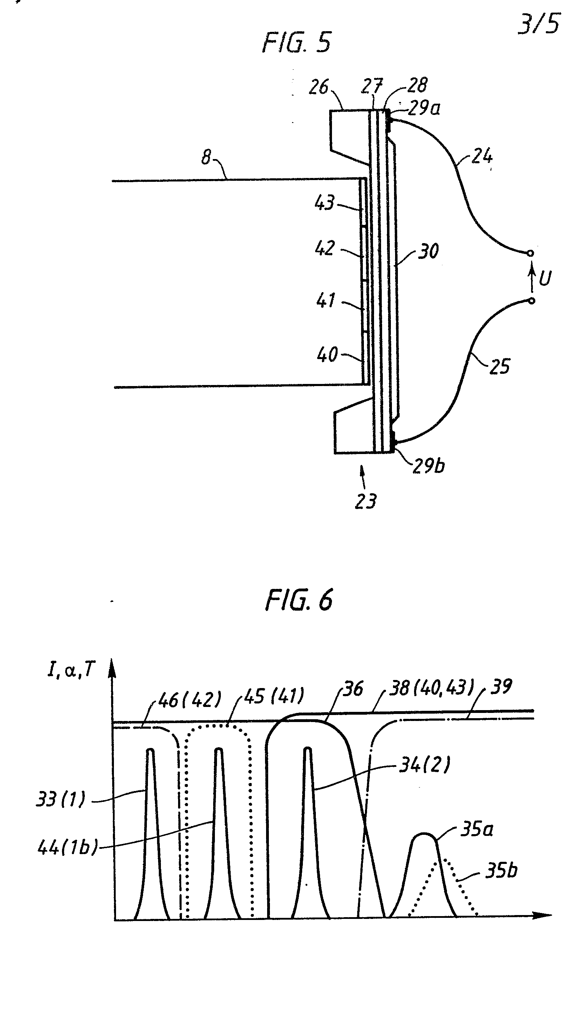

Mit dem Geber nach Figur 2 kann nur eine Gleichspannung U gemessen werden. Um Wechselspannungen messen zu können, kann ein Geber nach Figur 5 mit den spektralen Verhältnissen gemäß Figur 6 verwendet werden. Das Sensorelement selbst ist mit dem in Figur 2 gezeigten identisch; um jedoch die Lumineszenz von rekombinierenden Minoritätsladungsträgern messen zu können, die von dem Wechselspannungsfeld in der Schicht 28 im Sinne der Figur entweder nach oben oder nach unten verschoben wurden, enthält der Geber eine komplexere Filteranordnung (40, 41, 42 und 43) und eine weitere Lichtquelle mit dem Emissionsspektrum 44 in der Meßelektronik. Wenn die Lichtquelle 1 emittiert, man also das Emissionsspektrum 33 erhält, so wird die Schicht 28 nur hinter dem Filter 42 angeregt, das das Transmissionsspektrum 46 hat. Wenn U die Minoritätsladungsträger entsprechend Figur 5 nach oben zieht, so kann hinter dem Filter 43 (Transmissionsspektrum 38) Lumineszenzlicht erzeugt und durch das Filter 43 zum Detektor 17 geleitet werden. Wenn die Lichtquelle 1b (Emissionsspektrum 44) emittiert, so wird die Schicht 28 nur hinter dem Filter 41 (Transmissionsspektrum 45) angeregt, und wenn U umgekehrte Polarität hat und die Minoritätsladungsträger im Sinne der Figur 5 nach unten zieht, so kann Lumineszenzlicht hinter dem Filter 40 (siehe die Kurve 38) erzeugt und durch das Filter 40 zum Detektor 17 geleitet werden. Wenn schließlich die Lichtquelle 2 (Emissionsspektrum 34) emittiert, so wird die Schicht 28 sowohl hinter dem Filter 40 als auch hinter dem Filter 43 angeregt, und man erhält ein Bezugslumineszenzlichtsignal durch die Filter 40 und 43 (Transmissions-spektrum 38).

0095998

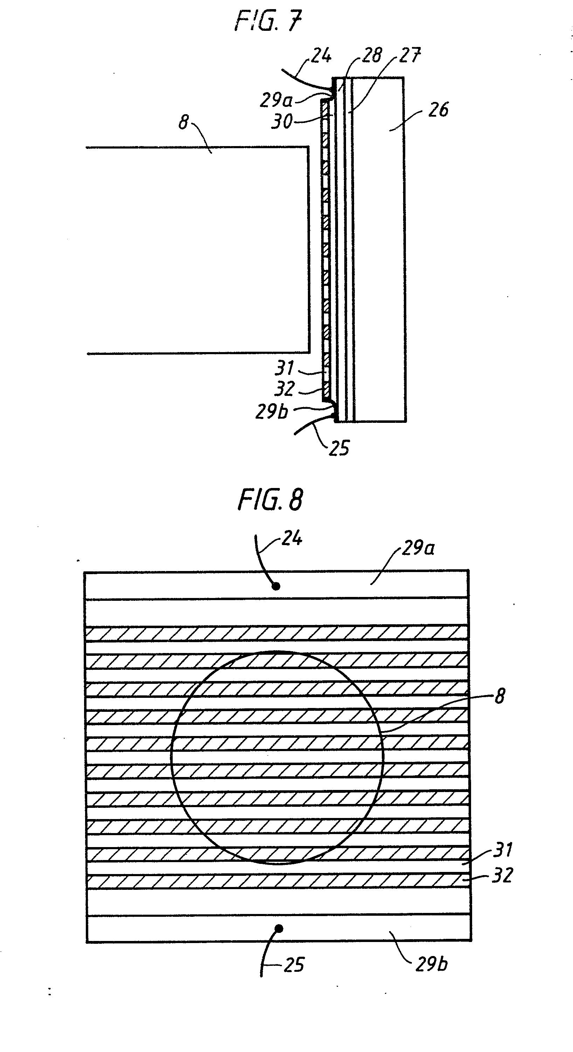

Das laterale elektrische Feld in der Schicht 28, das von der Spannung U zwischen den Elektroden 29a und 29b (siehe Fig. 2 und 3) erzeugt wird, beschleunigt optisch angeregte Ladungsträger und verschiebt den Schwerpunkt des Rekombinationsprozesses und damit die Lumineszenz. Dadurch, daß man eine Epitaxialschicht 28 von hoher Reinheit hinsichtlich Störzentren und Dislokationen züchtet, die Schicht 28 zwischen zwei der Schicht 28 gitterangepaßten Schichten 27 und 30 einschließt und niedrige Dotierungsniveaus in der Schicht 28 verwendet, die von derselben Art wie die Schichten 27 und 30 sein soll (p- oder n-leitend), kann man eine verhältnismäßig lange Lebensdauer der angeregten Minoritätsladungsträger erzielen und damit auch eine gute Modulation bei mäßigen Spannungen U. Für die Messung kleiner Spannungen kann es jedoch vorteilhaft sein, ein Raster aus optischen Filtern (31, 32) entsprechend Figur 7 und 8 zu verwenden, um einen multiplikativen Effekt und damit ein größeres Verhältnis von Nutzsignal zu Störpegel zu erhalten. Die Filter 32 und 31 in den Figuren 6 und 8 haben dieselben Eigenschaften wie die Filter 32 und 31 in Figur 2 (37 bzw. 38 in Figur 4). Sie sind bei der Ausführungsform nach Figur 7 jedoch unmittelbar auf der Schicht 30 angebracht. Bei dem Sensorelement gemäß Figur 7 braucht das Substrat 26 nicht für die Faser 8 weggeätzt zu werden. Hierdurch erhält man ein mechanisch stabileres Sensorelement, jedoch muß darauf geachtet werden, daß im Substrat keine Fotolumineszenz ausgelöst wird. Durch das Filterraster erhält man nicht nur ein größeres Verhältnis von Nutzsignal zu Störpegel, sondern es wird auch der Einfluß von mechanischen Verschiebungen zwischen Faser und Sensorelement auf das Meßsignal herabgesetzt.

Das laterale elektrische Feld in der lumineszierenden Schicht 28 kann außer von der Spannung U auch über eine oder mehrere Elektroden (47) gesteuert werden, die, ähnlich wie bei der Funktionsweise eines Feldeffekttransistors, die Energiebänder biegen und damit die laterale Verteilung

- 8 -

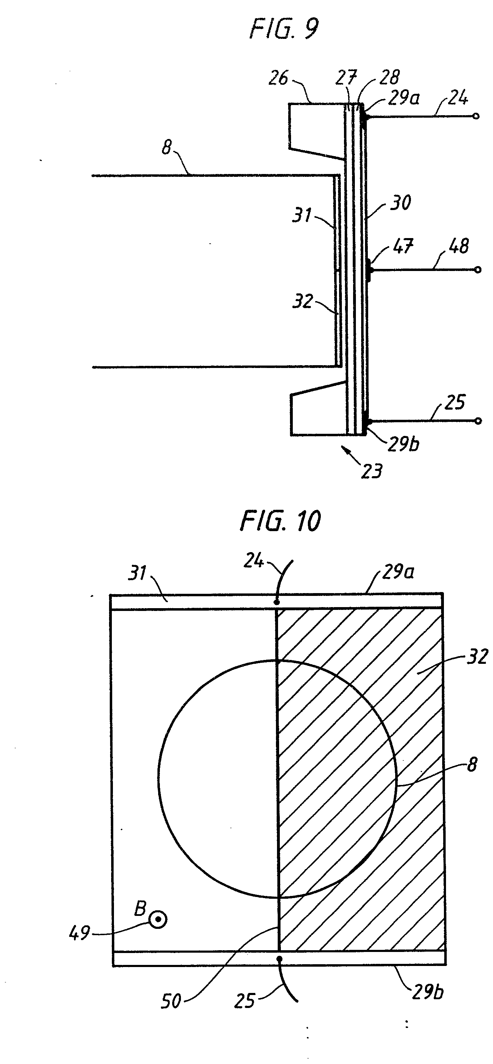

der Ladungsträger beeinflussen. Figur 9 zeigt ein solches Sensorelement. Es ist mit dem Sensorelement gemäß Figur 2 identisch mit Ausnahme des Merkmals, daß die Schicht 30 dünner ausgebildet ist und in einem Bereich mit einer Elektrode 47 belegt ist, deren Spannung über die Zuleitung 48 steuerbar ist. Mit Hilfe einer solchen Struktur, die der eines Feldeffekttransistors ähnlich ist, wird eine hochohmige Modulation der Lumineszenz ermöglicht sowie die Einführung einer Bezugsspannung in dasselbe Element, dem auch die Meßspannung zugeführt wird.

Schließlich zeigt Figur 10, wie das Sensorelement 23 mit der oben (siehe z.B. Fig. 2 und 3) beschriebenen Struktur zur Messung eines Magnetfeldes 49 verwendet werden kann, das senkrecht zur Oberfläche des Sensorelementes verläuft. Im Gegensatz zu der Filteranordnung (31, 32) bei den oben beschriebenen Ausführungsformen müssen bei dieser Ausführungsform die gemeinsamen Grenzlinien (50) zwischen den Filtern bei der Magnetfeldmessung mehr oder weniger parallel zu den zwischen den Elektroden 29a und 29b verlaufenden elektrischen Feldlinien liegen. Die durch das laterale elektrische Feld in der Schicht 28 modulierte Bewegung der optisch angeregten Ladungsträger wird von dem Magnetfeld abgelenkt, so daß die hinter einem der genannten Filter (32) erzeugte Ladungsträger in denjenigen Teil der genannten Schicht (28) gelangen, der sich hinter einem danebenliegenden Filter (31) befindet, so daß die hier bei der Rekombination erzeugte Lumineszenz zu dem Fotodetektor 17 gelangen kann.

Die Struktur nach Figur 10 ist also ein optischer Hall-Generator. Für die faseroptische Magnetfeldmessung können reihengeschaltete Fotodioden zur Erzeugung des elektrischen Feldes in der Schicht 28 verwendet werden. Da dieses Feld temperaturabhängig ist, wird es zweckmäßigerweise gleichzeitig nach einer der oben zur Spannungsmessung beschriebenen Methoden gemessen, so daß das Sensorelement mit optischen Filtern versehen ist, deren gemeinsamen Grenzlinien

/9

sowohl senkrecht als auch parallel zur Richtung des elektrischen Feldes in der Schicht 28 liegen.

Die Erfindung kann im Rahmen des offenbarten allgemeinen Erfindungsgedankens in vielfacher Weise variiert werden, um mit Hilfe einer von den Meßgrößen gesteuerten Verschiebung von optisch erzeugten Ladungsträgern eine Lumineszenz in einem solchen Bereich zu erzeugen, der eine andere Filtercharakteristik hat, als der Bereich, in dem die Ladungsträger erzeugt werden.

C Frankfurt/Main 1 , 5.5.1983
Rathenauplatz 2-8    21 280 PE
Telefon: (06 11) *28 23 55
Telex: 4 189 066 itax d

0095998

PATENTANSPRÜCHE:

1. Faseroptische Meßanordnung zum Messen von physikalischen Größen, insbesondere einer elektrischen Spannung oder eines Magnetfeldes, mit einem Geber (G), der über mindestens eine optische Faser (8) mit einer Meßelektronikeinheit (M) verbunden ist, wobei die Meßelektronik mindestens zwei Lichtquellen (1, 2) mit getrennten Emissionsspektren (33, 34) zur Erzeugung einer Fotolumineszenz (35) in einem im Geber vorhandenen Sensorelement (23) enthält und mindestens einen Fotodetektor (17) zur Erfassung des von dem Sensorelement ausgehenden Lumineszenzlichtes (35) enthält, dadurch gekennzeichnet, daß das Sensorelement (23) mindestens eine lumineszierende Schicht (28) enthält, daß Licht aus der optischen Faser (8) auf die Oberfläche der genannten Schicht (28) fällt, daß zwischen der Endfläche der optischen Faser (8) im Geber (G) und der Oberfläche der Schicht (28) mindestens ein optisches Filter (31, 32) im Strahlengang des Lichtes angeordnet ist und daß die Schicht (28) mit mindestens zwei derart angeordneten Elektroden (29a, 29b) versehen ist, daß durch die an die Elektroden angelegte Spannung in der Schicht (28) ein laterales elektrisches Feld erzeugt wird, welches die Ladungsträger beschleunigt, die von dem Licht aus der Faser (8) erzeugt werden.

2. Faseroptische Meßanordnung nach Anspruch 1, dadurch gekennzeichnet, daß mindestens eine der Lichtquellen (1) ein solches Emissionsspektrum (33) hat, daß ihr Licht durch das Filter (31, 32) nur auf einen oder mehrere Teile der Schicht (28) transmittiert wird, und daß der Geber so angeordnet ist, daß das Lumineszenzsignal bei dem genannten Emissionsspektrum (33) von der Größe des elektrischen Feldes abhängig ist, das die erzeugten Ladungsträger in der Schicht (28) beschleunigt.

3. Faseroptische Meßanordnung nach Anspruch 2, dadurch gekennzeichnet, daß die Erzeugung von Ladungsträgern in den Teilen der Schicht (28) erfolgt, die nicht mit einem Filter (31) versehen sind, welches Licht mit dem Emissionsspektrum (33) sperrt (38).

4. Faseroptische Meßanordnung nach Anspruch 2 oder 3, dadurch gekennzeichnet, daß ein Teil der beschleunigten Ladungsträger vor ihrer Rekombination in Teile der Schicht (28) gezogen werden, die mit einem Filter (31) versehen sind, welches Licht mit dem Emissionsspektrum (33) sperrt (38).

5. Faseroptische Meßanordnung nach Anspruch 2 oder 3, dadurch gekennzeichnet, daß ein Teil der beschleunigten Ladungsträger vor ihrer Rekombination in einen Bereich der Schicht (28) gezogen werden, der mit einem zwischen der Schicht (28) und der Faser (8) liegenden optischen Filter (31) versehen ist, dessen Durchlässigkeit (38) für das Lumineszenzlicht (35) sich von der Durchlässigkeit (37) für das Lumineszenzlicht (35) des Filters (32) unterscheidet, durch welches die Ladungsträger erzeugt werden.

6. Faseroptische Meßanordnung nach Anspruch 5, dadurch gekennzeichnet, daß das zweite Filter (31) das Lumineszenzlicht (35) transmittiert, während das Filter (32), durch das die Ladungsträger erzeugt werden, das Lumineszenzlicht sperrt.

7. Faseroptisches Meßgerät nach einem der Ansprüche 2 bis 6, dadurch gekennzeichnet, daß Licht von mindestens einer weiteren Lichtquelle (2) durch das Filter (31) transmittiert wird, wobei das Emissionsspektrum des Lichtes der Lichtquelle (2) so gewählt ist, daß vom Geber (G) in die optische Faser (8) ein Fotolumineszenzsignal gelangt, welches von dem genannten elektrischen Feld weniger stark abhängig ist und als Bezugssignal dient.

8. Faseroptische Meßanordnung nach Anspruch 7, dadurch gekennzeichnet, daß die Lichtquellen (1, 2) zeit- oder frequenzmultiplexiert betrieben werden, daß das Signal vom Fotodetektor (17a) zeit- bzw. frequenzmultiplexiert ist, daß der Fotodetektor (17b) mit einem optischen Filter (17a) zur Unterdrückung von reflektiertem Licht der Lichtquellen (1, 2) versehen ist, daß Licht von einer der Lichtquellen (1) Ladungsträger in demjenigen Bereich der Schicht (28) selektiv erzeugt, der sich hinter einem der optischen Sensorfilter (32) befindet, daß dieses Sensorfilter (32) Lumineszenzlicht (35) sperrt, daß neben diesem Sensorfilter (32) ein anderes Sensorfilter (31) angeordnet ist, das Lumineszenzlicht (35) transmittiert, daß das genannte elektrische Feld einen Teil der hinter dem Sensorfilter (32) optisch erzeugten Ladungsträger in denjenigen Teil der Schicht (28) hinüberzieht, der sich hinter dem zweiten Sensorfilter (31) befindet, daß Licht von einer zweiten Lichtquelle (2) zumindest in dem Teil der Schicht (28) Ladungsträger erzeugt, der sich hinter dem zweiten Filter (31) befindet, und daß zur Kompensation von variierender Dämpfung im optischen System, variierender Temperatur des Sensorelementes und Alterung des Sensorelementes entweder aus den beiden vom Detektor (17) erfaßten Lumineszenzsignalen in einem Quotientenbilder (21) der Quotient gebildet wird oder in Abhängigkeit des von der zweiten Lichtquelle (2) erzeugten Lumineszenzsignals die Lichtquellen (1, 2)und/oder der Detektorverstärker (18) geregelt wird.

9. Faseroptische Meßanordnung nach einem der vorhergehenden Ansprüche, dadurch gekennzeichnet, daß der Geber (G) beim Messen von Gleichspannungen mindestens zwei nebeneinander plazierte optische Filter mit nichtidentischen Transmissionsspektren enthält und beim Messen von Wechselspannungen mindestens drei nebeneinander plazierte Filter mit nichtidentischen Transmissionsspektren enthält und daß mindestens zwei beziehungsweise drei getrennte zeit- oder frequenzmultiplexiert betriebene Lichtquellen vorhanden sind, die verschiedene Teile der lumineszierenden Schicht (28) selektiv anzuregen vermögen.

Faseroptische Meßanordnung nach Anspruch 9, dadurch gekennzeichnet, daß bei der Wechselspannungsmessung eine erste Lichtquelle (1) die Schicht (28) hinter einem Filter (42) selektiv anregt, daß eine zweite Lichtquelle (2) die Schicht (28) hinter einem anderen Filter (41) selektiv anregt, daß beide Filter (41, 42) kein Lumineszenzlicht (35) transmittieren, daß beide Filter (41, 42) neben je einem Filter (40, 43) liegen, die Lumineszenzlicht transmittieren, wobei die Filter relativ zueinander so angeordnet sind, daß die von der Spannung beschleunigten Ladungsträger in der einen Halbperiode nur dann ein Lumineszenzsignal verursachen, wenn die erste Lichtquelle (1) eingeschaltet ist, und in der anderen Halbperiode nur, wenn die zweite (2) Lichtquelle (2) eingeschaltet ist.

11. Faseroptische Meßanordnung nach einem der vorhergehenden Ansprüche, dadurch gekennzeichnet, daß das genannte optische Filter (31, 32) als Raster aufgebaut ist, bei dem die Rasterelemente aus Streifen der genannten Filter bestehen, die nebeneinander angeordnet sind (Fig. 8).

12. Faseroptische Meßanordnung nach einem der vorhergehenden Ansprüche, dadurch gekennzeichnet, daß die lumineszierende Schicht (28) ein Halbleitermaterial, z.B. $Al_xGa_{1-x}As$, ist und daß diese Schicht auf beiden Seiten von Halbleiterschichten mit größerem Bandabstand umgeben ist, z.B. durch einen höheren Al-Gehalt in einer $Al_xGa_{1-x}As$-Struktur.

13. Faseroptische Meßanordnung nach einem der vorhergehenden Ansprüche, dadurch gekennzeichnet, daß das genannte laterale elektrische Feld von einer elektrischen Spannung modulierbar ist, die an mindestens eine Elektrode (47) anschließbar ist, welche nach Art eines Feldeffekttransistors das elektrische Feld in der lumineszierenden Schicht (28) ändert.

/14

14. Faseroptische Meßanordnung nach Anspruch 13, dadurch gekennzeichnet, daß die Elektrode (47) mit Hilfe einer elektrischen Spannung die Verschiebung von optisch erzeugten Ladunsträgern drosselt oder erleichtert.

15. Faseroptische Meßanordnung nach einem der vorhergehenden Ansprüche, dadurch gekennzeichnet, daß die zu messende Größe optisch erzeugte Ladungsträger aus mindestens einem Bereich der Schicht (28) in mindestens einem anderen Bereich der Schicht (28) verschiebt, daß diese Bereiche dadurch bestimmt werden, daß sie mit optischen Filtern (31, 32) mit getrennten Transmissionsspektren versehen sind, daß die Ladungsträger in einem dieser Bereiche der Schicht (28) erzeugt werden und in einem anderen dieser Bereiche der Schicht (28) rekombinieren und daß die genannten Filter unterschiedliche Transmissionscharakteristiken in Hinsicht auf die für die Lumineszenz und für die Erzeugung von Ladungsträgern maßgebenden Wellenlängen (35 bzw. 33, 34) haben.

16. Faseroptische Meßanordnung nach Anspruch 15, dadurch gekennzeichnet, daß die paarweise gemeinsamen Grenzlinien (50) der Filter (31, 32) bei der Spannungsmessung zumindest im wesentlichen senkrecht zu dem elektrischen Feld in der Schicht (28) und bei der Magnetfeldmessung zumindest im wesentlichen parallel zur Richtung des elektrischen Feldes in der Schicht (28) verlaufen.

17. Faseroptische Meßanordnung nach Anspruch 16, dadurch gekennzeichnet, daß das genannte elektrische Feld von der Ausgangsspannung von Fotodioden erzeugt wird und daß die optischen Filter (31, 32) sowohl zum Messen des elektrischen wie des magnetischen Feldes in der genannten Schicht (28) vorgesehen sind.

FIG. 1

FIG. 2

FIG. 3

FIG. 4

FIG. 5

FIG. 6

## FIG. 7

## FIG. 8

## FIG. 9

## FIG. 10

0095998

Europäisches
Patentamt

EUROPÄISCHER RECHERCHENBERICHT

Nummer der Anmeldung

EP 83 71 0029

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl. 3) |
|---|---|---|---|
| Y | DE-A-3 019 030 (ASEA AB) * Seite 9, Zeile 24 - Seite 10, Zeile 27; Seite 14, Zeile 21 -. Seite 15, Zeile 21; Figuren 1, 6 * | 1,12 | G 01 R 15/07 G 02 F 1/015 H 01 L 31/14 |
| | --- | | |
| Y | US-A-4 316 156 (D.R. SCIFRES et al.) * Zusammenfassung; Spalte 1, Zielen 39-55; Spalte 2, Zeile 22 - Spalte 3, Zeile 4; Figur 1 * | 1,12 | |
| | --- | | |
| D,A | DE-A-3 039 471 (ASEA AB) * Anspruch 1; Figuren 8, 9, 11 * | 1 | |
| | ----- | | |

RECHERCHIERTE SACHGEBIETE (Int. Cl. 3)

G 01 R 15/07
G 02 F 1/01
G 02 F 1/015
H 01 L 31/14

Der vorliegende Recherchenbericht wurde für alle Patentansprüche erstellt.

| Recherchenort BERLIN | Abschlußdatum der Recherche 30-08-1983 | Prüfer LEMMERICH J |
|---|---|---|